# EUROPÄISCHE PATENTSCHRIFT

(11) **EP 1 402 616 B1**
(45) Veröffentlichungstag und Bekanntmachung des Hinweises auf die Patenterteilung: **30.08.2006**
(21) Anmeldenummer: 02743153.5
(22) Anmeldetag: 06.06.2002
(51) Int. Cl.: H02K 11/00, F03D 11/00, G01R 31/02

(54) **SYNCHRONMASCHINE**
SYNCHRONOUS MACHINE
MACHINE SYNCHRONE

(30) Priorität: 20.06.2001 DE 10129365; 31.07.2001 DE 10137269
(43) Veröffentlichungstag der Anmeldung: 31.03.2004
(73) Patentinhaber: Wobben, Aloys, 26607 Aurich (DE)
(72) Erfinder: Wobben, Aloys, 26607 Aurich (DE)
(74) Vertreter: Eisenführ, Speiser & Partner
(86) Internationale Anmeldenummer: PCT/EP2002/006182
(87) Internationale Veröffentlichungsnummer: WO 2003/001649

(56) Entgegenhaltungen:
- EP-A- 0 253 085
- EP-A- 0 787 996
- PATENT ABSTRACTS OF JAPAN vol. 2002, no. 04, 4. August 2002 (2002-08-04) & JP 2001 346308 A (HITACHI CABLE LTD), 14. Dezember 2001 (2001-12-14)

## Beschreibung

Die vorliegende Erfindung betrifft eine Synchronmaschine mit bevorzugt Schenkelpolen mit Polwicklungen, welche untereinander galvanisch verbunden sind. Ferner betrifft die Erfindung eine Windenergieanlage sowie ein Verfahren zur Überwachung einer Synchronmaschine einer Windenergieanlage.

Synchronmaschinen sind allgemein bekannt. Eine Bauform ist die Ausbildung entweder des Läufers (Rotors) oder des Stators mit (Schenkel-)polen, wobei jeder Pol wenigstens eine Polwicklung aufweist, die ein Erregerstrom durchfließt. Dieser Erregerstrom ist bei Synchronmaschinen stets ein Gleichstrom.

Dabei sind die Polwicklungen aller oder mehrerer der einzelnen Schenkelpole galvanisch miteinander verbunden. Da die Polwicklungen jedoch einzeln hergestellt und montiert werden, erfolgt diese Verbindung durch geeignete Verbindungsmittel wie Klemmen, Lötverbindungen, etc. Insbesondere diese Verbindungsstellen, aber auch andere Stellen, an denen z.B. der Widdungsdraht beschädigt ist, unterliegen der Gefahr einer Unterbrechung der galvanischen Verbindung, z.B. in Folge der Vibrationen beim Betrieb der Maschine.

An dieser Unterbrechung kann sich infolge der hohen Stromstärke ein Lichtbogen ausbilden, derdurch Materialabtrag die Unterbrechung vergrößert und so selbst auch größer wird und mehrere Zentimeter lang werden kann. Dabei besteht die Gefahr, dass sich Material in der Umgebung entzündet und es somit zu einem Brand kommt, der die Maschine zerstört.

Aufgabe der Erfindung ist es daher, eine Synchronmaschine sowie ein Verfahren zum Betreiben einer Synchronmaschine derart weiterzubilden, dass die Gefahr eines Brandes verringert wird.

Diese Aufgabe wird bei einem Verfahren bzw. einer Synchronmaschine der eingangs genannten Art dadurch gelöst, dass die galvanische Verbindung (wenigstens einen) der Polwicklungen überwacht wird, und dass bei Unterbrechung der galvanischen Verbindung der Erregerstrom wenigstens verringert wird. Durch die Überwachung der galvanischen Verbindung kann eine Unterbrechung rechtzeitig erkannt werden. Die Verringerung des Erregerstromes verhindert dann die Ausbildung eines Lichtbogens, so dass die Gefahr einer Entzündung von Material in der Umgebung wirksam vermindert wird.

In einer bevorzugten Ausführungsform der Erfindung wird der Erregerstrom vollständig abgeschaltet, um einen möglicherweise vorhandenen Lichtbogen sicher zu löschen. Damit ist es bei rechtzeitiger Erkennung einer Unterbrechung möglich, einer Entstehung eines Brandes durch einen Lichtbogen zuverlässig vorzubeugen.

In einer besonders bevorzugten Weiterbildung der Erfindung lässt z.B. bei parallel geschalteten Gruppen von Polwicklungen nur diejenige Gruppe abgeschaltet, in welcher die Unterbrechung aufgetreten ist. Dadurch werden nur die Polwicklungen dieser Gruppe nicht mehr mit Strom versorgt, die übrigen Gruppen werden jedoch weiterhin von Erregerstrom durchflossen, so dass die Synchronmaschine weiter in Betrieb bleiben kann.

Um auf einfache Weise eine Unterbrechung und insbesondere einen Lichtbogen erkennen zu können, wird ein der galvanischen Verbindung eng benachbarter Leiter mit einem vorgebbaren Signal beaufschlagt und das Vorhandensein des Signals wird überwacht. Kommt es zur Ausbildung eines Lichtbogens, wird auch der benachbarte Leiter durch diesen Lichtbogen unterbrochen. Damit ist das Signal unterbrochen und gemäß dem erfindungsgemäßen Verfahren kann die Synchronmaschine entsprechend gesteuert werden.

Um den mechanischen Aufbau möglichst einfach zu gestalten, kann ein Leiter (Überwachungsleiter) vorgesehen sein, der parallel zu der oder schraubenförmig um die galvanische Verbindung herum verläuft bzw. um die galvanische Verbindung gewickelt oder an diese angebracht oder geklebt ist.

In einer besonders bevorzugten Ausführungsform der Erfindung ist der Überwachungsleiter ein elektrischer Leiter, z.B. ein üblicher isolierter Kupferdraht. Dieser ist kostengünstig verfügbar und lässt sich auf einfache Weise erfindungsgemäß anbringen. Auch das Einspeisen eines vorgebbaren Signals ist bei einem elektrischen Leiter mit geringem Aufwand möglich. In einer altemativen Ausführungsform ist der Überwachungsleiter ein optischer Leiter. Bei diesem erfordert zwar das Beaufschlagen mit Signalen einen höheren Aufwand, dafür sind die Signale jedoch unempfindlich gegen elektromagnetische Einflüsse und weisen somit eine höhere Störsicherheit auf.

Um die Funktionssicherheit des erfindungsgemäßen Verfahrens und der Synchronmaschine zu erhöhen, können insbesondere eine erste Vorrichtung zum Beauf schlagen des Überwachungsleiters mit einem Signal und eine zweite Vorrichtung zum Überwachen des Signals redundant vorgesehen sein. Dadurch kann bei Ausfall einer Komponente deren Funktion von einer redundant vorhandenen übemommen werden.

Im folgenden wird die Erfindung anhand der Figuren näher beschrieben. Dabei zeigen:
- Figur 1: einen sektionsförmigen Ausschnitt eines Polrades;
- Figur 2: eine vergrößerte Detaildarstellung aus Figur 1;
- Figur 3: eine vereinfachte Darstellung eines Leiters in einer ersten Ausführüngsform der Erfindung mit einem elektrischen Leiter,
- Figur 4: eine alternative Ausführungsform einer Überwachung mit einem optischen Leiter,
- Figur 5: eine Überwachung ohne einen zusätzlichen Leiter;
- Figur 6: eine Darstellung einer Windenergieanlage mit einer von einem Sicherungsdraht umwickelten Stromschiene.

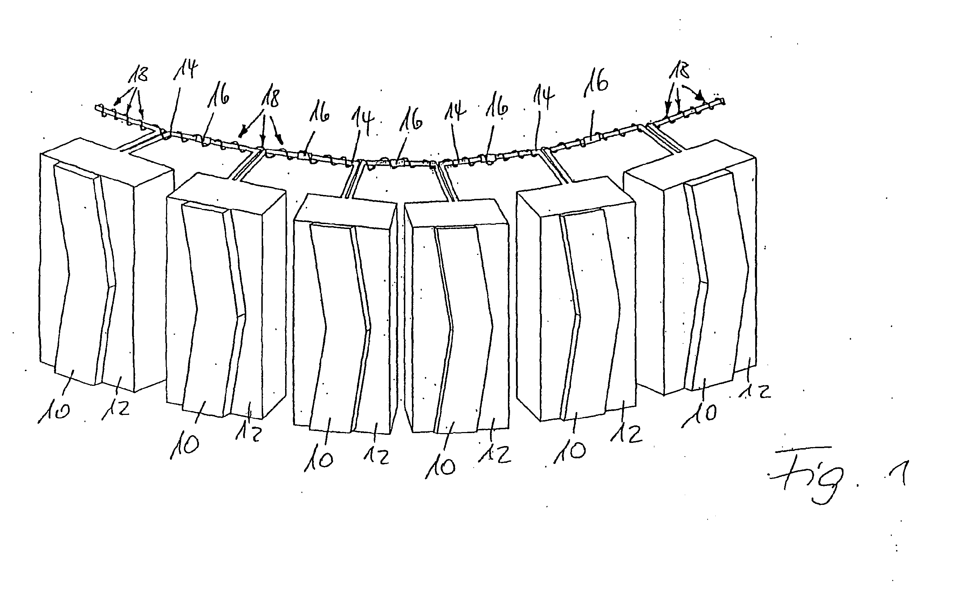

Figur 1 zeigt vereinfacht eine Sektion eines Polrades einer Synchronmaschine (Generator). Das Bezugszeichen 10 bezeichnet die einzelnen Polschuhe der Schenkelpole, während 12 die auf den Schenkeln angeordneten Polwicklungen bezeichnet.

Diese Polwicklungen 12 sind untereinander durch eine galvanische Verbindung 14 verbunden, so dass die Polwicklungen 12 in Reihe geschaltet sind und somit alle von dem gleichen Strom durchflossen werden. Da die Polwicklungen 12 einzeln hergestellt werden, erfolgt eine Verbindung der Anschlüsse untereinander z.B. durch Verbindungshülsen 16.

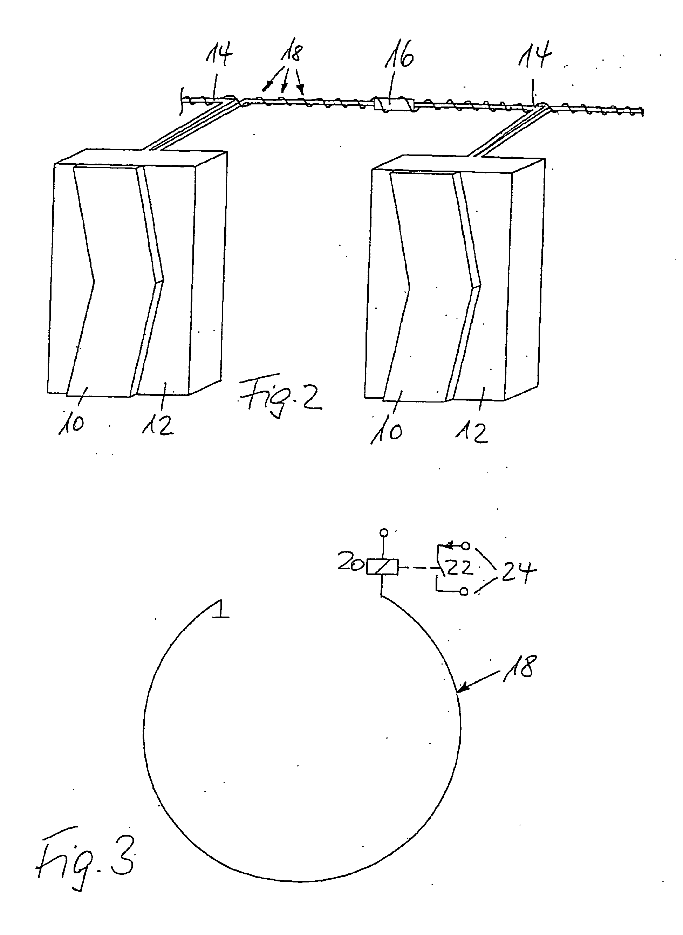

Figur 2 ist eine vergrößerte Detailansicht aus Figur 1 und zeigt zwei Polschuhe 10 mit dahinter angeordneten Polwicklungen 12. Zwischen den Polwicklungen 12 besteht ein galvanische Verbindung 14. Diese wird hergestellt, indem der Leiter 14, aus dem die Polwicklung 12 gewickelt ist, an einer Verbindungsstelle 16 z.B. mit einer Verbindungshülse 16 oder durch eine Lötverbindung oder eine andere geeignete Verbindung mit dem Leiter der benachbarten Polwicklung 12 verbunden wird. Derartige Verbindungsstellen 16 befinden sich auch wiederum zwischen den beiden in dieser Figur dargestellten Polwicklungen 12 und ihren jeweils, wiederum benachbarten (aber nicht dargestellten) Polwicklungen 12. insbesondere diese Verbindungsstellen 16 sind aber strukturelle. Schwachpunkte in dieser galvanischen Verbindung 14, so dass des dort z.B. in Folge der im Betrieb der Synchronmaschine auftretenden Vibrationen zu einer Unterbrechung kommen kann.

Um die galvanische Verbindung 14 und die Verbindungsstelle 16 herum ist ein schraubenförmig gewundener Leiter 18 als Überwachungseinrichtung bzw. Überwachungsleiter dargestellt.

Kommt es z.B. durch Vibration an der Verbindungsstelle 16 zu einer Unterbrechung, bildet sich dort ein Lichtbogen aus, weil die Unterbrechung anfangs sehr klein und der Erregerstrom relativ hoch ist. Durch den Lichtbogen wird Material abgetragen und dadurch die Unterbrechung vergrößert. Dieser Materialabtrag durch den Lichtbogen unterbricht jedoch auch den Leiter 18, so dass durch eine geeignete Überwachung des Leiters 18 diese Unterbrechung erkannt und damit auf eine Unterbrechung der galvanischen Verbindung 14 und die Ausbildung eines Lichtbogens geschlossen werden kann. Daraufhin können geeignete Maßnahmen, wie die Abschaltung des Erregerstromes, ergriffen werden, um den Lichtbogen zu löschen, und somit die Entstehung eines Brandes zu verhindern.

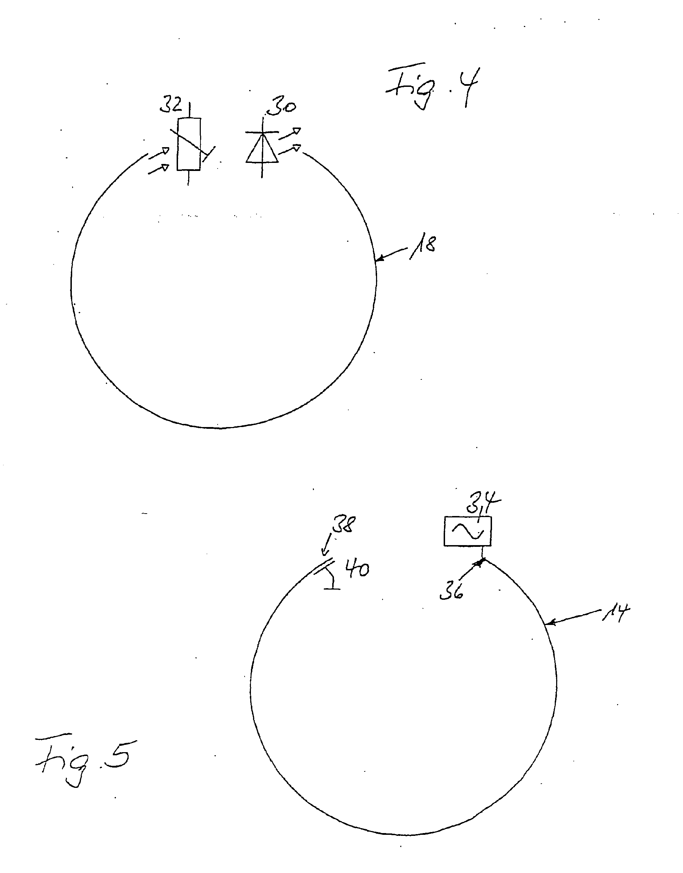

In Figur 3 ist in vereinfachter Weise eine Möglichkeit der Überwachung mit einem Leiter 18 dargestellt Dieser Leiter 18 ist an einer Seite auf Massepotential gelegt. An der anderen Seite des Leiters ist ein Schaltelement 20, in diesem Fall ein Relais, vorgesehen, das mit einer ausreichenden Spannung beaufschlagt wird, damit es anziehen kann. Dieses Relais weist einen Öffner 22 auf, der somit bei angezogenem Relais 20 geöffnet ist. Kommt es nun zu einer Unterbrechung des Leiters 18, fällt das Relais 20 ab und der Öffner schließt. Dieses Schließen kann z.B. an den Anschlussklemmen 24 durch eine nachgeschaltete Einrichtung erkannt und entsprechend ausgewertet werden.

Natürlich ist auch die Anordnung des Relais an der anderen Seite des Leiters 18 möglich. Dann wird der Leiter mit einer geeigneten Spannung beaufschlagt, die das Relais 20 anziehen lässt, und auch dabei fällt das Relais 20 natürlich ab, sobald der Leiter 18 unterbrochen wird, was unmittelbar zur Abschaltung des Erregerstroms führen kann.

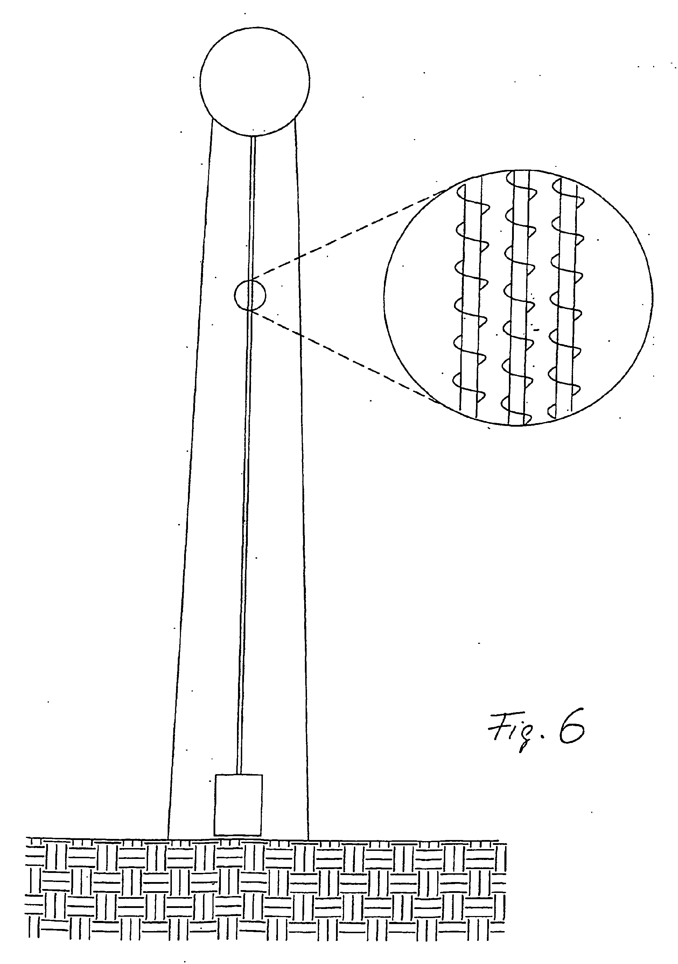

In Figur 4 ist eine alternative Ausführungsform der in Figur 3 gezeigten Überwachung dargestellt. Der Leiter 18 ist in Figur 4 ein Lichtwellenleiter. In diesen Lichtwellenleiter 18 wird von einer Lichtquelle 30, hier als Leuchtdiode dargestellt, ein optisches Signal eingekoppelt, das an dem anderen Ende durch einen Empfänger 32, im vorliegenden Beispiel ein Fotowiderstand, der wiederum Bestandteil einer Brückenschaltung sein kann, empfangen wird.

So lange also das von der Lichtquelle 30 ausgesandte Licht durch den Leiter 18 übertragen wird, hat der Empfänger 32 einen bestimmten Widerstandswert. Kommt es zu einer Unterbrechung des Leiters 18, gelangt das von der Lichtquelle 30 eingespeiste Licht nicht mehr zu dem Empfänger 32, dieser verändert seinen Widerstandswert und damit kann die Unterbrechung des Leiters 18 erkannt werden.

Natürlich kann der Empfänger auch beispielsweise als Fototransistor oder als jedes beliebige andere, lichtempfindliche Element ausbildet sein.

Eine alternative Form der Überwachung des galvanischen Leiters 14 ist in Figur 5 dargestellt Dabei wird an einem Einkopplungspunkt 36 zusätzlich zu dem fließenden Erregerstrom eine Wechselspannung mit geringer Amplitude und vorgegebener Frequenz überlagert. An dem Auskopplungspunkt 38 wird diese Wechselspannung überwacht. Dabei kann die Auskopplung z.B. kapazitiv oder induktiv erfolgen. In der Figur ist dazu ein Belag 40 eines Kondensators dargestellt. Der andere Belag kann z.B. durch die galvanische Verbindung 14 selbst gebildet werden.

Durch eine geeignete, nachgeordnete Schaltung kann wiederum die durch den Kondensator 40 ausgekoppelte Wechselspannung überwacht werden. Kommt es zu einer Unterbrechung der galvanischen Verbindung 14, wird zwar der Erregerstrom durch den Lichtbogen noch transportiert, die überlagerte Wechselspannung jedoch nicht mehr, so dass diese am Auskopplungspunkt 38 auch nicht mehr ausgekoppelt werden kann. Dadurch kann die Unterbrechung der galvanischen Verbindung 14 erkannt werden.

Wenn mehrere Polwicklungen zu einer Gruppe zusammengeführt sind und mehrere Gruppen solcher Polwicklungen bestehen, bietet es sich an, für jede Gruppe einen eigens vorgesehenen Sicherungsdraht auszubilden, so dass bei Unterbrechung des Sicherungsdrahtes nur der Erregerstrom der betroffenen Gruppe verringert bzw. abgeschaltet wird, so dass die übrigen Gruppen wie üblich -weiterbetrieben werden können, um einen Weiterbetrieb des Generators zu ermöglichen.

Ist also für jede Polwicklungsgruppe ein eigener Sicherungsdraht vorgesehen (natürlich mit der entsprechenden Einspeise- und Übeiwächungsvorrichtung), so ergibt dies eine eindeutige Zuordnung von der Polwicklungsgruppe und dem jeweiligen Sicherungsdraht und entsprechend kann bei Auftrennung des Sicherungsdrahtes die Ansteuerung der Polwicklungsgruppe unterbrochen werden. Eine weitere Möglichkeit ist die Verwendung eines einzelnen Sicherungsdrahtes für die Polwicklung des gesamten Polrades und das Abschalten des Erregerstroms im Falle einer Unterbrechung des Sicherungsdrahtes. Wird diese Unterbrechung, die für eine vorgegebene Zeitspanne beibehalten werden muss, um den Lichtbogen sicher zu löschen, wieder aufgehoben, kann wieder ein entsprechender Erregerstrom fließen. Davon ausgenommen ist dann lediglich die Polwicklungsgruppe, in welcher die Unterbrechung aufgetreten ist. Bei dieser Lösung ist jedoch unter Umständen nachteilig, dass dann der Sicherungsdraht unterbrochen ist, so dass entweder der Betrieb ohne Sicherungsdraht fortgesetzt werden muss oder aus Gründen der Betriebssicherheit nicht fortgesetzt werden kann.

Die Erfindung ist nicht etwa nur auf die Überwachung des Generators der Windenergieanlage beschränkt, sondem kann auch auf andere Teile des Windenergieanlage angewandt werden. So tritt beispielsweise das Problem der Lichtbogenentstehung nicht nur bei Unterbrechung der Polwicklungen auf, sondem kann auch bei Unterbrechung von Gleichstromschienen entstehen, mit denen die vom Generator erzeugte elektrische Energie von der Gondel zu den Leistungsschränken, die regelmäßig im Fuß des Turmes oder außerhalb des Turmes angeordnet sind, entstehen. Diese Gleichstromschienen bestehen regelmäßig aus einem Metall, beispielsweise Aluminium, und werden am Turminneren an der Turmwandung befestigt und heruntergeführt. Da der Turm sich aufgrund der gesamten Windbelastung der Windenergieanlage auch bewegt (im Bereich der Gondel kann diese Bewegung in ihrer Amplitude leicht im Bereich von 0,5 m bis 2 m liegen), werden auch die Stromschienen entsprechend mit bewegt und belastet, was im ungünstigen Fall, wenn die Bewegungen zu stark waren oder keine saubere Verlegung der Stromschienen erfolgt ist, zu einer Unterbrechung der Stromschienen führen kann, wodurch sich ebenfalls ein Lichtbogen zwischen den unterbrochenen Teilen ausbilden kann und da an dieser Stelle sehr große Energieflüsse zu verzeichnen sind, kann dies zu einem sehr großen Schaden an der Windenergieanlage führen, zumal es auch durchaus möglich ist, dass der entstehende Lichtbogen auf den geerdeten Turm überspringt, so dass auch der Ausbruch eines Brandes nicht ausgeschlossen werden kann.

Die dargestellte Ausführung nach Figur 6 zeigt im Teilausriss die Umwicklung einer dreiadrigen Stromschiene mit einem Sicherungsdraht, wobei für die Überwachung des Sicherungsdrahtes die aus den Figuren 3 bis 5 bekannten Überwachungseinrichtungen verwendet werden können. Tritt die Unterbrechung einer Stromschiene auf, so führt dies auch zur Unterbrechung des Sicherungsdrahtes und in einem solchen Fall wird die gesamte Anlage zum Eigenschutz abgeschaltet und nicht weiterbetrieben, zumal ohnehin dann die Stromschienen (Gleichstromschienen) nicht nur repariert, sondem unter Umständen auch ausgetauscht werden müssen, um einen sicheren Weiterbetrieb zu gewährleisten. Die Stromschienen dienen im dargestellten Beispiel wie üblich dazu, die elektrische Leistung vom Generator in der Gondel der Windenergieanlage vom Turmfuß bzw. den dort angeordneten elektrischen Einrichtungen wie Wechselrichter und/oder Transformator zu leiten.

## Patentansprüche

1. Synchronmaschine mit einem Läufer (Rotor), welcher eine Vielzahl von Polen aufweist, die jeweils mit wenigstens einer Potwicklung versehen sind, wobei die Polwicklungen mehrerer Pole untereinander galvanisch mittels eines ersten Leiters, durch den ein Erregerstrom fließt, verbunden sind, **dadurch gekennzeichnet, dass** im Wesentlichen parallel zum ersten Leiter ein Überwachungsleiter verlegt ist, welcher mit einem vorgebbaren Signal beaufschlagt ist oder beaufschlagbar ist, dass der Überwachungsleiter mit einer Vorrichtung zur Erfassung des Signals gekoppelt oder verbunden ist und dass bei Unterbrechung des ersten Leiters dieses durch eine Signalveränderung im Überwachungsleiter festgestellt wird bzw. feststellbar ist und die Vorrichtung zur Erfassung des Signals mit einer Steuereinrichtung gekoppelt ist, die dann den Erregerstrom durch den ersten Leiter wenigstens verringert, vorzugsweise abschaltet.

2. Synchronmaschine nach Anspruch 1,
**gekennzeichnet durch** einen schraubenförmig um die galvanische Verbindung herum verlaufenden Überwachungsleiter.

3. Synchronmaschine nach Anspruch 1 oder 2,
**dadurch gekennzeichnet, dass** der Überwachungsleiter als elektrischer Leiter und/oder optischer Leiter ausgebildet ist.

4. Synchronmaschine nach einem der vorhergehenden Ansprüche,
**dadurch gekennzeichnet, dass** die Vorrichtung zum Beaufschlagen des Überwachungsleiters mit einem Signal redundant ausgebildet ist und bevorzugt aus einer ersten und zweiten Vorrichtung zum Beaufschlagen des Leiters mit einem Signal besteht

5. Synchronmaschine nach Anspruch 4,
**dadurch gekennzeichnet, dass** die erste und zweite Vorrichtung zur Beaufschlagung des Überwachungsleiters mit einem Signal eine bauliche Einheit bildet.

6. Windenergieanlage mit einer Synchronmaschine nach einem der vorhergehenden Ansprüche..

7. Verfahren zur Überwachung des Betriebs einer Synchronmaschine, die einen Läufer (Rotor) aufweist, welcher aus mehreren Polen mit einer Polwicklung besteht, wobei die Polwicklungen mehrerer Pole untereinander galvanisch verbunden sind und durch die Polwicklungen ein Erregerstrom fließt, wobei Mittel zur Überwachung der galvanischen Verbindung der Polwicklungen vorgesehen sind wobei als Mittel zur Überwachung der galvanischen Verbindung ein Überwachungsleiter bereit gestellt wird und bei Unterbrechung der galvanischen Verbindung dieses durch eine Signalveränderung im Überwachungsleiter fest gestellt wird und daraufhin der Erregerstrom wenigstens verringert, vorzugsweise abgeschaltet wird.

8. Verfahren nach Anspruch 7,
**dadurch gekennzeichnet, dass** bei mehreren parallel geschalteten Gruppen von Polwicklungen der Erregerstrom in der Gruppe der Polwicklungen mit der galvanischen Unterbrechung abgeschaltet wird, in anderen Gruppen hingegen vorzugsweise aufrecht erhalten wird.

9. Verfahren nach einem der Ansprüche 7 oder 8,
**dadurch gekennzeichnet, dass** zur Erkennung der galvanischen Unterbrechung dem Erregerstrom an wenigstens einer vorgebbaren ersten Position der galvanischen Verbindung eine Wechselspannung vorgebbarer Frequenz und/oder Amplitude überlagert wird und das Vorhandensein dieser Wechselspannung an wenigstens einer zweiten vorgegebenen Position mittels einer entsprechenden Überwachungseinrichtung überwacht wird.

10. Verfahren nach einem der vorhergehenden Ansprüche,
**dadurch gekennzeichnet, dass** zur Erkennung einer galvanischen Unterbrechung ein zu der galvanischen Verbindung mit vorgegebenen Abstand benachbarter Überwachungsleiter mit einem vorgebbaren Signal beaufschlagt wird und das Vorhandensein des vorgegebenen Signals überwacht wird und bei Ausfall oder vorgegebener Veränderung des vorgegebenen Signals eine Steuerungseinrichtung dazu veranlasst wird, den Erregerstrom zu verringem und/oder gänzlich abzuschalten.

11. Windenergieanlage mit einem Rotor und damit gekoppeltem Generator, welcher bei Betrieb der Windenergieanlage eine elektrische Leistung zur Verfügung stellt, welche mittels Stromschienen vom Generator aus dem Bereich der Gondel in den Fußbereich des Turmes geführt wird und dort für die Einspeisung in ein Versorgungsnetz aufbereitet wird, wobei im Wesentlichen parallel zur Stromschiene ein Überwachungsleiter verlegt ist, welcher mit einem vorgebbaren Signal beaufschlagt ist oder beaufschlagbar ist, wobei der Überwachungsleite (Sicherungsdraht) mit einer Vorrichtung zur Erfassung des Signals gekoppelt oder verbunden ist und dass bei Unterbrechung der Stromschiene dieses durch eine Signalveränderung im Überwachungsleiter festgestellt wird bzw. feststellbar ist und die Vorrichtung zur Erfassung des Signals mit einer Steuerungseinrichtung gekoppelt ist, die dann den Strom durch diese Stromschiene wenigstens verringert, vorzugsweise abschaltet.

12. Windenergieanlage mit den Merkmalen nach einem der Ansprüche 2 bis 5.

13. Windenergieanlage nach Anspruch 11,
**dadurch gekennzeichnet, dass** der Überwachungsleiter um eine einzelne Stromschiene oder um eine Gruppe von Stromschienen gewickelt ist und parallel weitestgehend vom Beginn bis zum Ende der Stromschiene verläuft.

## Claims

1. Synchronous machine having a rotor which has a multiple number of poles each of which is provided with at least one pole winding, the pole windings of a plurality of poles being galvanically interconnected by means of a first conductor through which an energising current flows, **characterised in that** a monitoring conductor is laid substantially parallel to the first conductor, which monitoring conductor is or can be acted upon by a predefinable signal, the monitoring conductor is coupled or connected to a device for detecting the signal, and, upon interruption of the first conductor, this is or can be established by a change in the signal in the monitoring conductor, and the device for detecting the signal is coupled to a control device which then at least reduces, and preferably switches off, the energising current through the first conductor.

2. Synchronous machine according to claim 1,
**characterised by** a monitoring conductor that extends helically about the galvanic connection.

3. Synchronous machine according to claim 1 or claim 2,
**characterised in that** the monitoring conductor is in the form of an electrical conductor and/or an optical conductor.

4. Synchronous machine according to any one of the preceding claims,
**characterised in that** the device for acting upon the monitoring conductor with a signal is of a redundant design and preferably consists of a first and a second device for acting upon the conductor with a signal.

5. Synchronous machine according to claim 4,
**characterised in that** the first and the second device for acting upon the monitoring conductor with a signal forms a structural unit.

6. Wind power installation having a synchronous machine according to any one of the preceding claims.

7. Method for monitoring the operation of a synchronous machine having a rotor which consists of a plurality of poles with a pole winding, the pole windings of a plurality of poles being galvanically interconnected and an energising current flowing through the pole windings, wherein means for monitoring the galvanic connection of the pole windings are provided, wherein a monitoring conductor is provided as the means for monitoring the galvanic connection, and, upon interruption of the galvanic connection, this is established by a change in the signal in the monitoring conductor and thereupon the energising current is at least reduced and preferably switched off.

8. Method according to claim 7,
**characterised in that**, in the case of a plurality of parallel-connected groups of pole windings, the energising current in the group of pole windings having the galvanic interruption is switched off, whereas in other groups it is preferably maintained.

9. Method according to either claim 7 or claim 8,
**characterised in that** for detection of the galvanic interruption an a.c. voltage of a predefinable frequency and/or amplitude is superimposed on the energising current at at least one predefinable first position of the galvanic connection, and the presence of that a.c. voltage at at least a second predefined position is monitored by means of an appropriate monitoring device.

10. Method according to any one of the preceding claims,
**characterised in that** for detection of a galvanic interruption a monitoring conductor adjacent to the galvanic connection is acted upon by a predefinable signal and the presence of the predefined signal is monitored and, upon loss of or change in the predefined signal, a control device is caused to reduce and/or completely switch off the energising current.

11. Wind power installation having a rotor and a generator coupled thereto which in operation of the wind power installation provides electrical power which is passed by means of busbars from the generator out of the region of the nacelle to the base region of the tower and is processed there for being fed into a supply grid, wherein a monitoring conductor is laid substantially parallel to the busbar, which monitoring conductor is or can be acted upon by a predefinable signal, wherein the monitoring conductor (fuse wire) is coupled or connected to a device for detecting the signal and, upon interruption of the busbar, this is or can be established by a change in the signal in the monitoring cable, and the device for detecting the signal is coupled to a control device which then at least reduces, and preferably switches off, the current through that busbar.

12. Wind power installation having the features according to any one of claims 2 to 5.

13. Wind power installation according to claim 11,
**characterised in that** the monitoring conductor is wound around an individual busbar or around a group of busbars and extends parallel very substantially from the beginning to the end of the busbar.

## Revendications

1. Machine synchrone dotée d'une roue motrice (rotor), laquelle présente une pluralité de pôles qui sont respectivement munis d'au moins un bobinage de pôles, les bobinages de pôles de plusieurs pôles étant reliés entre eux de manière galvanique au moyen d'un premier conducteur à travers lequel un courant d'excitation circule, **caractérisée en ce que** principalement en parallèle au premier conducteur est placé un conducteur de surveillance, lequel est alimenté ou peut être alimenté par un signal prédéfinissable, **en ce que** le conducteur de surveillance est couplé ou relié à un dispositif de détection du signal et **en ce que** lors de l'interruption du premier conducteur, ceci est constaté ou peut-être constaté par une modification du signal dans le conducteur de surveillance et le dispositif de détection du signal est couplé à un dispositif de commande qui réduit alors au moins, de préférence interrompt, le courant d'excitation à travers le premier conducteur.

2. Machine synchrone selon la revendication 1,
**caractérisée par** un conducteur de surveillance se profilant de manière hélicoïdale autour de la liaison galvanique.

3. Machine synchrone selon la revendication 1 ou 2,
**caractérisée en ce que** le conducteur de surveillance est formé comme conducteur électrique et/ou optique.

4. Machine synchrone selon l'une des revendications précédentes,
**caractérisée en ce que** le dispositif d'alimentation du conducteur de surveillance par un signal est redondant et se compose de préférence d'un premier et d'un deuxième dispositifs pour alimenter le conducteur par un signal.

5. Machine synchrone selon la revendication 4,
**caractérisée en ce que** le premier et le deuxième dispositifs pour l'alimentation du conducteur de surveillance par un signal forment une unité de construction.

6. Installation d'énergie éolienne dotée d'une machine synchrone selon l'une des revendications précédentes.

7. Procédé de surveillance du fonctionnement d'une machine synchrone qui présente une roue motrice (rotor),laquelle est composée d'une pluralité de pôles avec un bobinage de pôles, de sorte que les bobinages de pôles de plusieurs pôles sont reliés entre eux de manière galvanique et un courant d'excitation circule à travers les bobinages de pôles, des moyens étant prévus pour surveiller la liaison galvanique des bobinages de pôles, un conducteur de surveillance étant mis à disposition comme moyen de surveillance de la liaison galvanique et lors de l'interruption de la liaison galvanique, ceci est constaté par une modification du signal dans le conducteur de surveillance et qu'à la suite de cela, le courant d'excitation est au moins réduit, de préférence interrompu.

8. Procédé selon la revendication 7,
**caractérisé en ce que** dans plusieurs groupes de bobinages de pôles montés en parallèle, le courant d'excitation est interrompu avec l'interruption galvanique dans le groupe de bobinages de pôles et est en revanche maintenu de préférence dans d'autres groupes.

9. Procédé selon l'une des revendications 7 ou 8,
**caractérisé en ce que** pour reconnaître l'interruption galvanique, une tension alternative de fréquence et/ou d'amplitude prédéfinissable est superposée au courant d'excitation sur au moins une première position prédéfinissable de la liaison galvanique et la présence de cette tension alternative sur au moins une deuxième position prédéfinie est surveillée au moyen d'un dispositif de surveillance correspondant.

10. Procédé selon l'une des revendications précédentes,
**caractérisé en ce que** pour reconnaître une interruption galvanique, un conducteur adjacent à la liaison galvanique avec un écart prédéfini est alimenté par un signal prédéfinissable et la présence du signal prédéfini est surveillée et qu'en cas de perte ou de modification prédéfinie du signal prédéfini, un dispositif de commande est déclenché pour réduire et/ou interrompre totalement le courant d'excitation.

11. Installation d'énergie éolienne dotée d'un rotor et d'un générateur qui lui est couplé, lequel met à disposition, lors du fonctionnement de l'installation d'énergie éolienne, une puissance électrique qui est acheminée au moyen de barres conductrices depuis le générateur au niveau de la nacelle jusqu'au niveau du pied de la tour et y est préparée dans un réseau d'alimentation pour l'alimentation, de sorte qu'un conducteur de surveillance est monté principalement en parallèle à la barre conductrice, lequel est alimenté ou peut être alimenté par un signal prédéfinissable, le conducteur de surveillance (fil de sécurité) étant couplé ou relié à un dispositif de détection du signal et qu'à l'interruption de la barre conductrice, cela est constaté ou peut être constaté par une modification du signal dans le conducteur de surveillance et le dispositif de détection du signal est couplé à un dispositif de commande, lequel réduit alors au moins, de préférence interrompt, le courant à travers cette barre conductrice.

12. Installation d'énergie éolienne possédant les attributs selon l'une des revendications 2 à 5.

13. Installation d'énergie éolienne selon la revendication 11,
**caractérisée en ce que** le conducteur de surveillance est enroulé autour d'une seule barre conductrice ou d'un groupe de barres conductrices et se profile en parallèle dans la mesure du possible depuis le début jusqu'à la fin de la barre conductrice.
